(19) Europäisches Patentamt
European Patent Office
Office européen des brevets

(11) **EP 1 755 298 B1**

(12) **EUROPEAN PATENT SPECIFICATION**

(45) Date of publication and mention
of the grant of the patent:
**15.07.2009 Bulletin 2009/29**

(51) Int Cl.:
*H04L 25/03* (2006.01)   *H04B 7/08* (2006.01)

(21) Application number: **06252731.2**

(22) Date of filing: **25.05.2006**

(54) **Joint space-time optimum filters for interference cancellation**

Gemeinsame Raum-Zeit optimale Filter zur Interferenzunterdrückung

Filtres optimaux espace-temps conjoints pour l'annulation d'interférence

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.08.2005 CA 2516000**

(43) Date of publication of application:
**21.02.2007 Bulletin 2007/08**

(73) Proprietor: **Research In Motion Limited Waterloo, Ontario N2L 3W8 (CA)**

(72) Inventors:
• **Wu, Huan Kanata, Ontario K2M 2W8 (CA)**
• **Simmons, Sean Waterloo, Ontario N2T 1E7 (CA)**
• **Kemenczy, Zoltan Mississauga, Ontario L5L 2L8 (CA)**

(74) Representative: **Fennell, Gareth Charles et al Kilburn & Strode LLP 20 Red Lion Street London WC1R 4PJ (GB)**

(56) References cited:
**US-A- 5 821 988**       **US-A1- 2003 063 596**
**US-A1- 2005 250 466**   **US-B1- 6 314 147**

• **KOHNO R: "SPATIAL AND TEMPORAL COMMUNICATION THEORY USING ADAPTIVE ANTENNA ARRAY" IEEE PERSONAL COMMUNICATIONS, IEEE COMMUNICATIONS SOCIETY, US, vol. 5, no. 1, February 1998 (1998-02), pages 28-35, XP000737860 ISSN: 1070-9916**

## Description

## Cross-Reference to Related Applications

This application claims the benefit of U.S. Provisional Application No. 60/684,312, filed May 25, 2005, and 60/708,278, filed August 15, 2005, which is hereby incorporated herein in its entirety by reference.

## Field of the Invention

The present invention relates to wireless communications systems, such as cellular communications systems, and, more particularly, to filtering received wireless signals to reduce unwanted interference.

## Background of the Invention

Interference canceling matched filters (ICMF) and joint demodulation (JDM) has been investigated to meet requirements for a Downlink Advanced Receiver Performance (DARP) that is standardized by the third generation mobile communications system and the Third Generation Partnership Project (3GPP). Some of these proposals are set forth in the following articles and documents.

1.Liang et al., A Two-Stage Hybrid Approach for CCI/ISI Reduction with Space-Time Processing, IEEE Communication Letter Vol. 1, No. 6, Nov. 1997.
2.Pipon et al., Multichannel Receives Performance Comparison In the Presence of ISI and CCI, 1997 13th Intl. Conf. on Digital Signal Processing, July 1997.
3.Spagnolini, Adaptive Rank-One Receiver for GSM/DCS Systems, IEEE Trans. on Vehicular Technology, Vol. 51, No.5, Sept. 2002.
4.Feasibility Study on Single Antenna Interference Cancellation (SAIC) for GSM Networks, 3GPP TR 45.903 Version 6.0.1, Release 6, European Telecommunications Standards Institute, 2004.
5.Radio Transmission and Reception (Release 6), 3GPP TS 45.005 Version 6.8.0; European Telecommunications Standards Institute, 2005.
6.Stoica et al., Maximum Likelihood Parameter and Rank Estimation in Reduced-Rank Multivariate Linear Regressions, IEEE Trans. On Signal Processing, Vol. 44, No.12, Dec. 1996.
7. Kristensson et al., Blind Subspace Identification of a BPSK Communication Channel, Proc. 30th Asilomar Conf. On Signals, Systems and Computers, 1996.
8. Golub et al., Matrix Computations, 3rd Edition, 1996.
9. Trefethen et al., Numerical Linear Algebra, 1997.
10. Press et al., Numerical Recipes in C, 2nd Edition, 1992.

Current Global System for Mobile communications (GSM) cellular systems have to address the co-channel interference (CCI) on the mobile station (MS) side, as well as address the DARP requirements. Some single channel structures and pre-filters have been used to aid in canceling the interference and provide some channel impulse response (CIR) estimation. Moreover, some systems have used maximization of the signal-to-interference to design jointly a single channel space-time filter and the CIR estimation for a single channel. Other systems have used a constrained minimization of the mean-square error to design a single channel space filter. Other systems have used a single channel space filter that is designed by a rank-one approximation of the ML channel estimation. The target applications for these systems have been a base station where a physical antenna array including a plurality of antennas is available.
"Spatial and Temporal Communication Theory Using Adaptive Antenna Array" by Kohno, R and published in IEEE Personal Communication, IEEE Communications Society, US, vol. 5, no. 1, February 1998, pages 28-35 ISSN: 1070-9916, describes an adaptive antenna array that can form a desired antenna pattern and adaptively control it if an appropriate set of antenna weights is provided an updated in software. This document describes spatial and temporal communication theory based on an adaptive antenna array, such as spatial and temporal channel modelling, equalization, optimum detection for single-user and multi-user CDMA, precoding in transmitter, and joint optimization of both transmitter and receiver.
United States patent number 6,314,147 discloses a two-stage CCI/ISI reduction with space-time processing in TDMA cellular networks. The first stage uses a space-time linear filter to process the received signal and provide an intermediate signal with substantially reduced co-channel interference content and substantially unaltered intersymbol interference content relative to that of the received signal. The second stage uses a Viterbi equalizer to estimate the data symbols from the intermediate signal.
United States patent number 5,821,988 discloses an NTSC co-channel interference reduction system. This document describes a digital television receiver operating in the presence of an NTSC co-channel signal including an NTSC rejection filter that is selectively inserted in the digital television signal path to minimise interference from the NTSC co-channel signal.

United States patent application number US 2003/0063596 discloses a method and apparatus for canceling co-channel interference in a receiving system using spatio-temporal whitening. A spatio-temporal interference canceling method is described which effectively cancels co-channel interference despite frequency offset between the signal and the interferer in a TDMA type system. Real and imaginary component values of the total received signal are used for virtual diversity branches, and a vector-valued auto regressive model is used to characterize the interference.

## Brief Description of the Drawings

Various objects, features and advantages will become apparent from the following detailed description, when considered in light of the accompanying drawings, in which:

FIG. 1 is a block diagram of a Joint Space-Time Optimum Filter based Downlink Advanced Receiver Performance (DARP) capable receiver in accordance with an embodiment of the invention;

FIG. 2 is a more detailed block diagram of the Joint Space-Time Optimum Filter and Multi-Channel Matched Filters shown in FIG. 1 in accordance with an embodiment of the invention;

FIG. 2A is a block diagram of a method in accordance with the present invention;

FIG. 3 is a graph showing the Joint Space-Time Optimum Filter based DARP capable receiver performance for various DARP test cases;

FIG. 4 is a graph showing the Joint Space-Time Optimum Filter receiver performance in accordance with the present invention with additive white Gaussian noise (AWGN), compared with and without an auto-switching strategy;

FIG. 5 is a graph showing the Joint Space-Time Optimum Filter receiver performance in accordance with the present invention with DTS-5, compared with and without auto-switching;

FIG. 6 is a graph comparing the performance of single with multiple Viterbi equalizers in accordance with the present invention, using 8-bit SD limiter in the simulation;

FIG. 7 is a graph showing the performance of Joint Space-Time Optimum Filter Receiver and a modified test case in accordance with the present invention;

FIG. 8 is a schematic block diagram of an exemplary model wireless communication device that can be used in accordance with one embodiment of the present invention; and

FIG. 9 is a table comparing the three approaches for performing Cholesky, QR, and SVD computations in accordance with the present invention.

## Detailed Description of the Preferred Embodiments

Several non-limiting embodiments will now be described more fully hereinafter with reference to the accompanying drawings, in which preferred embodiments are shown. These embodiments may, however, be embodied in many different forms and should not be construed as limited to the embodiments set forth herein. Rather, these embodiments are provided so that this disclosure will be thorough and complete, and will fully convey the scope to those skilled in the art. Like numbers refer to like elements throughout, and prime notation is used to indicate similar elements in alternative embodiments.

In accordance with one embodiment, Co-Channel Interference (CCI) on a mobile station (MS) side in a current Global System for Mobile (GSM) communications system is addressed, as well as the compliant requirement of a Downlink Advanced Receiver Performance (DARP) standard by the Third Generation Partnership Project (3GPP).

The invention may generally be summarized as follows. A wireless communications device may include at least one virtual antenna and a space-time filter circuit for filtering a communications signal received by the at least one virtual antenna by jointly estimating space-time filter weights and at least one channel impulse response (CIR). The device may further include a matched filter circuit downstream from the space-time filter circuit and having a filter response that is provided by a channel impulse response estimation from the space-time filter circuit.

The at least one virtual antenna may split the communications signal into n signal parts. More particularly, the at least one virtual antenna may split the communications signal into odd and even sampled, real and imaginary n signal parts. Furthermore, the space time filter circuit may be a multi-channel, space-time filter circuit that filters the n signal parts by jointly estimating space-time filter weights and multi-channel impulse responses. In addition, the multi-channel, space-time filter circuit may include at least one multiplier for multiplying each signal part by a respective space-time filter weight.

By way of example, the at least one multiplier may be a pair thereof connected in parallel, and the multi-channel, space-time filter circuit may further include a respective delay circuit for each signal part connected to an input of one of the pair of multipliers. Also, the communications signal may include a plurality of symbols, and the multipliers and delay circuits may each have about a one-symbol delay associated therewith. A respective summer circuit may also be included for summing outputs of the multipliers for each channel. The wireless communications device may further include an equalizer circuit downstream from the matched filter circuit.

A method of reducing co-channel interference within a wireless communications device receiver may include providing at least one virtual antenna and filtering a communications signal received by the at least one virtual antenna using a space-time filter circuit by jointly estimating space-time filter weights and at least one channel impulse response (CIR). The method may further include generating a filter response based upon a channel impulse response estimation from the space-time filter circuit using a matched filter circuit downstream from the space-time filter circuit.

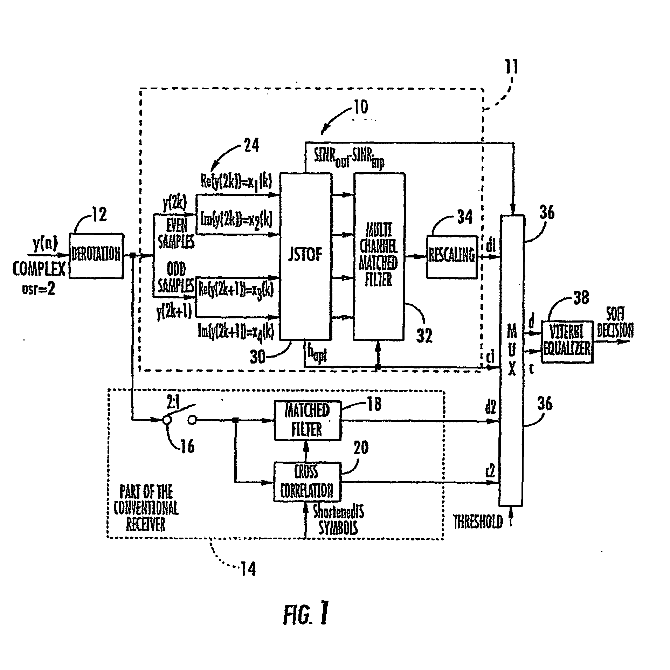

The illustrated embodiment in FIG. 1 provides a multi-channel pre-filter that is operable for canceling the interference and providing channel impulse response (CIR) estimation adaptively and optimally. The pre-filter can use two major components in one non-limiting example: (1) a multiple-input-multiple-output (MIMO) based Joint Space-Time Optimum Filter (JSTOF); and (2) a multiple-input-single-output (MISO) based multi-channel matched filter. In a typical mobile station using a single available antenna, a virtual antenna array can be configured internally by the combination of over sampling and the separation of real and imaginary parts that receive samples.

In one non-limiting embodiment, a signal from the virtual antenna array is fed to the JSTOF, where the optimum weights for the MIMO-based interference canceling filter are estimated. At the same time, the multi-channel CIRs for the desired signal are jointly estimated. The output of the JSTOF allows the interference to be filtered and fed to a MISO-based multi-channel matched filter. The filter response of the matched filter is provided by the CIR estimation from the JSTOF.

The output of the multi-channel matched filter passes to a Viterbi equalizer which removes the inter-symbol interference (ISI) and provides soft decisions for further processing. A single channel response required by the equalizer can be formed by a combination of the convolved CIRs from the JSTOF. This pre-filter can also automatically switch to the conventional or standard filter in the conventional receiver in any AWGN dominant cases and switch back to the JSTOF-based receiver in any interference dominant cases. This auto-switching capability reduces the loss in AWGN dominant cases.

An example of the pre-filter or interference canceling filter for the JSTOF-based and DARP-capable receiver is shown at **10** in FIG. 1, in which the oversampling ratio is 2 and the number of the virtual antennas is 4 (M = 4), as also indicated by $X_1(k)$ through $X_4(k)$. Throughout this description the pre-filter **10** can be referred to as the interference canceling filter or JSTOF filter, and acts as a pre-filter in a DARP compliant receiver. A receiver incorporating this filter **10** could be described as a JSTOF receiver as is shown by the dashed line at **11** in FIG. 1.

FIG. 1 shows examples of the various circuit blocks used for the filter **10.** An input signal is received into a derotation circuit **12.** The derotated output signal is split, with a portion passing into a filter **14** of a conventional receiver that includes a 2:1 switch 16, and an output into a matched filter **18** and a cross-correlation circuit **20** that receives shortened training sequence (TS) symbols. The 2:1 switch **16** is operable to allow switching between the filter **14** and the JSTOF-based and DARP-capable pre-filter **10.**

The other portion of the output signal from the derotation circuit **12** is split into even samples and odd samples as part of the virtual antenna **24** and split again into real and imaginary signals to form the respective $X_1(k)$ through $X_4(k)$ input signals into a JSTOF circuit **30,** also referred to as a multi-channel, space-time filter circuit. It should be noted that a virtual antenna arrangement need not be used in all examples. That is, the filter **18** may be used for filtering signals directly from one or more physical (i.e., real) antennas, such as in a phase shift keying (PSK) application (e.g., 8PSK), for example. The output signals from the JSTOF circuit are passed into a multi-channel matched filter circuit **32,** and its output signal is passed into a rescaling circuit **34** and then into a multiplexer circuit **36** as data $(d_1)$. The multiplexer circuit **36** also receives a channel $(c_1)$ response. When the conventional filter **14** is connected, the multiplexer **36** receives the data $(d_2)$ and channel $(c_2)$ response from the matched filter circuit **18** and cross-correlation circuit **20.** Signals are passed into a Viterbi equalizer **38** as a soft decision output.

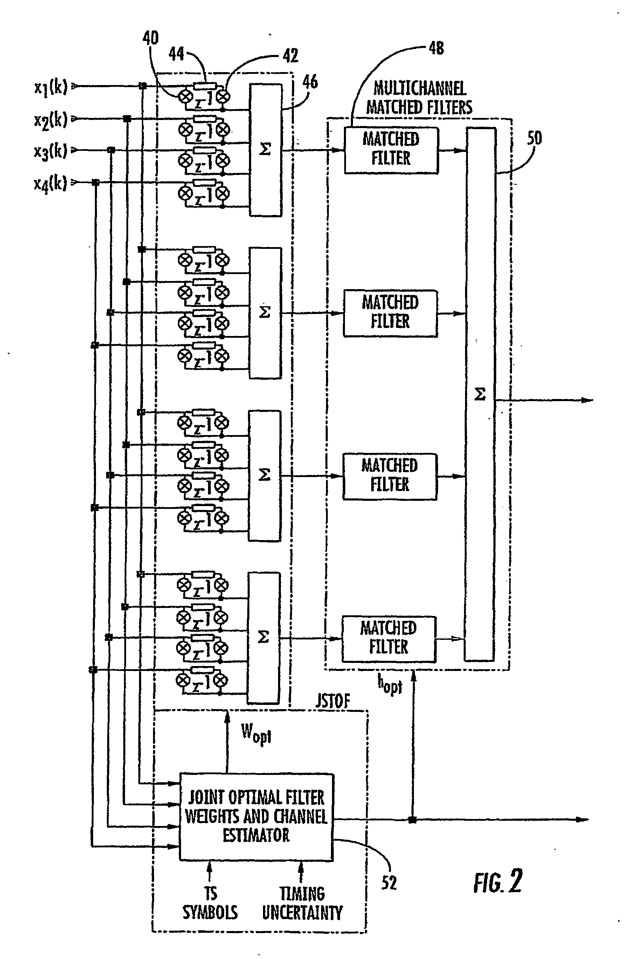

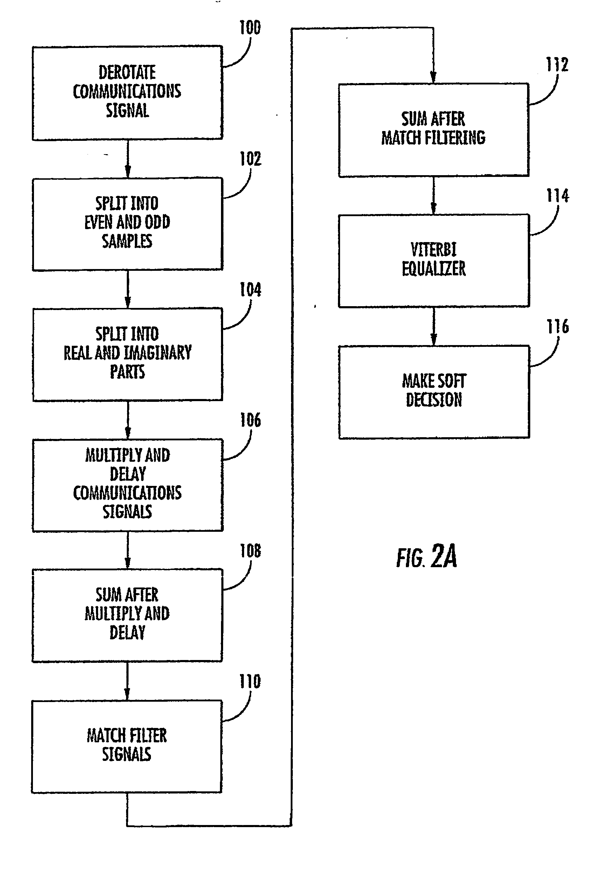

Further details of the JSTOF and the multi-channel matched filters are shown in FIG. 2, where the number of time-delayed samples used in the JSTOF circuit is 2 (N = 2). The various inputs $X_1(k)$ through $X_4(k)$ are received into the JSTOF, which is shown in greater detail. The JSTOF circuit **30** includes channelized multipliers, also termed mixers **40, 42,** delay units **44** and summers **46,** which input into multi-channel matched filters **48** for each of the four illustrated channels, and signals from the matched filters are passed into a summer **50.** A joint optimal filter weights and channel estimator circuit **52** receives TS symbols and timing uncertainty signals to produce the weights $(W_{OPT})$ used for the mixers **40, 42.**

It thus is possible as described to integrate a pre-filter function into a conventional GSM receiver by adding a pre-filter branch parallel to a conventional matched filter as shown in FIG. 1. The conventional software/hardware Viterbi equalizer **38** can be used without change. In one non-limiting example, an integrated DARP-capable receiver has been tested against DARP test cases by simulations, which indicates that the receiver provides 1.6 dB to 6.9 dB margin over a specified performance in terms of the frame error rate (FER) for one of the AMR speech channels.

FIG. 2a is a flow chart illustrating a high-level method associated with the described system in which the various steps are shown as non-limiting examples. The various steps begin with the 100 series reference numerals. The incoming communications signal is derotated (Block 100) and passed into the virtual antenna. The communications signal is split into even and odd samples (Block 102), and each even and odd sample is then split into real and imaginary signal parts (Block 104). The communications signals from the virtual antenna are passed into the JSTOF circuit, where the communications signals are multiplied and delayed (Block 106) and then summed (Block 108), all as part of a first multiple-in, multiple-out (MIMO) Joint Space Time Optimum Filter (JSTOF). After summing, summed signals are passed into the multi-channel, multiple-input single-output (MISO) matched filter circuit (Block 110) and then summed (Block 112) and passed as a single out signal into the Viterbi equalizer (Block 114) in which a soft decision is made (Block 116).

In operation, the derotation circuit **12** is operable with GMSK modulated signals and the frequency offset that is part of that signaling protocol. Before any derotation, the signal constellation is dynamic and after derotation the signal constellation becomes static, i.e., any symbols are typically concentrated on 0° and 180°, with symbols rotated to those two points. Thus, the GMSK signal can be treated as a typical binary phase shift keying (BPSK) signal. The derotation at the front end is used for even and odd samplings, which is useful because of the over-sampling rate. For example, in a conventional receiver, this is typically at the rate of 1, i.e., one sample per symbol.

The virtual antenna **24** can increase the sampling rate to two samples per symbol in a serial manner coming from the baseband filter to form two separate channels of even and odd. Before this process, the odd/even samples were serially interleaved. These signals are then further split into the real and imaginary signal parts to form the four independent channels of the virtual antenna. It should be noted that in some embodiments other numbers of virtual antennas/channels may be used (e.g., one or more), as will be appreciated by those skilled in the art.

As best shown in FIG. 2, these signals are then passed into the multiplier **40,42** and unit delay circuits **44,** e.g., a one symbol delay, and thus the signal is processed with a multiply and delay, followed by a multiply operation as evident by the two multipliers **40, 42** and one delay circuit **44.** This operation is followed by a summation in summer **46** as illustrated. This portion of the system is operable as a multi-channel, two-dimensional filter. One dimension occurs because of the delay in time and another dimension is introduced from the virtual antenna, i.e., a spatial dimension as described and thus the two dimensions form a space-time filter.

It is evident each incoming signal is used in conjunction with other channels, and multipliers receive weights from the Joint Optimal Filter Weights and Channel Estimator **52.** The weights coming from the Joint Optimal Filter Weight and Channel Estimator **52** are passed into the multipliers.

The weights are also an 8 x 4 dimensional matrix in one non-limiting example, i.e., 32 weights. As to the training sequence symbols input into the Joint Optimal Filter Weights and Channel Estimator **52,** there are typically in some non-limiting examples about 26 known symbols and it is known which training sequence a packet contains. A +/-3 or seven positions search in a non-limiting example can be used to find the timing. The impulse response of the multi-channel matched filter ($h_{opt}$) can be used such that the system matches the channel response and makes the signal stronger after the matched filter.

As shown in FIG. 1, rescaling can occur as a hardware or software convenience, although it is not required. This rescaling circuit **34** allows greater operation for a 4-bit or 5-bit input as a non-limiting example to the Viterbi equalizer **38.** The dynamic range of the signal can be readjusted such that the signal can be sent into a 4-bit or 5-bit circuit.

As noted before, the multiplexer **36** can take the signals $d_2$ and $c_2$ for the data and channel response from the conventional filter receiver **14** or the signals $d_1$ and $c_1$ for the data and channel response from the JSTOF receiver **10** to allow a switch-over between the two. The JSTOF receiver will introduce some loss if there is no interference, i.e., just pure white noise. In this case the conventional receiver **14** can be used and will work adequately. So, the circuits can switch back to the conventional filter without loss introduced by the JSTOF receiver and its circuits. The switching is based on the estimation of the $SINR_{OUT}$ minus $SINR_{INP}$. If the quantity is below a threshold, the system determines there is little interference and the interference canceling of the JSTOF receiver is not required. Thus, the filter of the conventional receiver **14** is used by switching the 2:1 switch **16.**

The circuit is operable in beam forming systems and other systems. This type of system also allows the signal-to-noise ratio to be improved and the bit error rate (BER) to be improved. This could impact top level protocols and phone calls and other communications matters for use with these circuits.

The multi-channel structure of the JSTOF-based filter **10** is used in one embodiment, and the MIMO-based JSTOF circuit **30** provides a space-time filter weight and channel estimations that are different from prior art solutions. This circuit provides the ability to combat the interference efficiently for both synchronous and asynchronous interferences and yield high performance. Some simulations have shown that none of the solutions in some prior art techniques provide the required performance against the DARP test cases.

This MISO-based multi-channel matched filter circuit **32** is a feature that improves the overall error rate performance and reduces the complexity of the equalizer by avoiding multi-channel Viterbi equalizers. The built-in automatic switching between JSTOF-based and conventional receivers reduce the loss in AWGN cases.

Suitable receiver structures can be used in order to meet the DARP requirements. An Interference Canceling Matched Filter (ICMF) can use an example of the virtual antenna as described and beamforming to combat the interference. The circuit is sensitive to the estimation errors of the Channel Impulse Response (CIR) of the desired signal. A Joint Demodulation (JD) showed good performance for the various test cases. In addition to the difficulty in combating the asynchronous interferers, there may be heavy computational complexity involved in finding the CIR of an interferer.

In one embodiment, the virtual antenna **24** is operable with adaptive space-time filtering, allowing the Joint Spatial-Temporal Optimum Filter (JSTOF) circuit **30** to be used. One difference from the ICMF is that the spatial-temporal filter weights used to suppress the interference and the CIR estimation of the desired signal are jointly estimated and optimized in the JSTOF while the two are separately estimated in an ICMF. The JSTOF circuit 30 can be a Multiple-Input-Multiple-Output (MIMO) circuit that takes advantage of the rank deficiency nature of the desired CIR matrix in the space-time setup. Simulations have shown a satisfactory performance for the various DARP test cases. Computational load is deemed acceptable given that fixed-point Cholesky factorization and EVD/SVD are feasible.

This method has some simplicity and low computational complexity. It is also robust because the system makes few assumptions about the source of the interference. In addition, the system can continue to use the existing equalizer structure, as the solution is integrated as a pre-processing step on the input data. This would allow the system to use the HW equalizer accelerators if available.

In order to support the evaluation of this technique, the system level Block Error Rate (BLER) simulator was extended to support all of the interferer models/scenarios being used by the 3GPP DARP Specification.

There now follows a description of the simulation performance for DARP test cases using the JSTOF circuit. It should be understood that space-time processing for joint interference reduction and channel estimation has been used in a base station, where an array of M antennas is available. Assuming that the equivalent channel response for the single desired user can be modeled as an L-tap Finite Impulse Response (FIR) filter, a snapshot sample of the received baseband signal can be expressed as

$$\mathbf{x}(k) = \sum_{l=0}^{L-1} \mathbf{c}(l) s_{k-l} + \mathbf{v}(k) = \mathbf{H}\mathbf{s}(k) + \mathbf{v}(k), \tag{1}$$

where x(k) is an Mx 1 vector representing the output from the antennas, H is an M×L matrix containing the channel response for the antenna array, s(k) is an Lx 1 vector for the corresponding symbols transmitted, and v(k) is an M× 1 vector including the AWGN and the interference. The space-time extension for formula (1) can be obtained by stacking N time-delayed versions of x(k) into a taller MN×1 vector $\bar{\mathbf{x}}(k)$ as follows:

$$\bar{\mathbf{x}}(k) = \left[\mathbf{x}^T(k), \mathbf{x}^T(k-1), \cdots, \mathbf{x}^T(k-N+1)\right]^T = \overline{\mathbf{H}}\bar{\mathbf{s}}(k) + \bar{\mathbf{v}}(k), \tag{2}$$

where $\overline{\mathbf{H}}$ an MN×(L+N-1) matrix is the block Toeplitz version of H and $\bar{s}(k)$=[$s_k$, $s_{k-1}$,..., $s_{k-L-N+2}$]T. The samples that correspond to the training sequence can be collected,

$$\overline{\mathbf{X}} = \left[\bar{\mathbf{x}}(k), \bar{\mathbf{x}}(k+1), \cdots, \bar{\mathbf{x}}(k+p-1)\right] \approx \overline{\mathbf{H}}\overline{\mathbf{S}} + \overline{\mathbf{V}}, \tag{3}$$

where p = P - L - N + 2, P is the number of symbols of the training sequence, $\bar{x}$ is an MN×p matrix, and s = [$\bar{s}$(k), $\bar{s}$(k+1), ..., $\bar{s}$(k+p-1)] is an (L+N-1)×p convolution matrix of the training symbols. The joint optimization is to find a non-trivial MN×1 weight vector **w** for a space-time filter and a non-trivial (L+N-1)×1 channel estimation vector h after the filter such that the output interference residual of the filter is minimized, i.e., to solve the following optimization problem:

$$\min_{\mathbf{w}, h} \left\| \mathbf{w}^T \overline{\mathbf{X}} - \mathbf{h}^T \overline{\mathbf{S}} \right\|^2. \tag{4}$$

It can be found that the optimal weight is:

$$\mathbf{w}_{opt} = \mathbf{R}_x^{-1} \mathbf{R}_{xs} \mathbf{h}_{opt}, \tag{5}$$

and the optimal channel estimation $\mathbf{h}_{opt}$ is the eigenvector corresponding to the minimum eigenvalue of the matrix

$\mathbf{R}_s - \mathbf{R}_{xs}^H \mathbf{R}_x^{-1} \mathbf{R}_{xs}$, where

$$\mathbf{R}_x = \overline{\mathbf{X}}^* \overline{\mathbf{X}}^T, \quad (\text{MN} \times \text{MN}) \tag{6}$$

$$\mathbf{R}_s = \overline{\mathbf{S}}^* \overline{\mathbf{S}}^T, \quad ((\text{L+N-1}) \times (\text{L+N-1})) \tag{7}$$

and

$$\mathbf{R}_{xs} = \overline{\mathbf{X}}^* \overline{\mathbf{S}}^T, \quad ((\text{MN}) \times (\text{L+N-1})). \tag{8}$$

Given that the noise plus interference component $\overline{V}$ in the space-time model of equation (3) is no longer white but approximately Gaussian distributed with unknown covariance matrix $\mathbf{R}_V$, the optimal estimation for the channel $\overline{\mathbf{H}}$ is the maximum-likelihood (ML) estimation, which is a minimization of the following quantity:

$$\lambda(\overline{\mathbf{H}}, \mathbf{R}_v) = \log|\mathbf{R}_v| + \left\| \overline{\mathbf{X}} - \overline{\mathbf{H}}\overline{\mathbf{S}} \right\|_{\mathbf{R}_v^{-1}}^2. \tag{9}$$

In this non-limiting space-time model, the number of the independent channels is always less than or equal to M and $\overline{\mathbf{H}}$ is usually rank deficient, i.e., rank($\overline{\mathbf{H}}$) = r < min(MN, L+N-1). The rank deficient ML problem can be used for the rank-1 approximation of the space-time filter.

The JSTOF circuit in one embodiment can use a different approach to find the joint optimum solutions for the filter weight and the channel estimation. It is possible to find the ML estimation of $\overline{\mathbf{H}}$. The estimation can be decomposed as

$$\hat{\mathbf{H}}^* = \hat{\mathbf{H}}_s \hat{\mathbf{H}}_t^H, \tag{10}$$

where $\hat{H}_s$ (MN×M) is the estimation of the space matrix of $\overline{\mathbf{H}}$ and $\hat{H}_t$ ((L+N-1)×M) is the estimation of the time matrix of $\overline{\mathbf{H}}$. They can be obtained by:

$$\hat{\mathbf{H}}_t = \mathbf{R}_s^{-1/2} \mathbf{V}_{DM}, \tag{11}$$

and

$$\hat{\mathbf{H}}_s = \mathbf{R}_{xs} \hat{\mathbf{H}}_t, \tag{12}$$

where $\mathbf{R}_s = \mathbf{R}_s^{1/2} \mathbf{R}_s^{H/2}$ is the Cholesky factorization and $\mathbf{V}_{DM}$ consists of the **M** eigenvectors corresponding to the top M eigenvalues of the matrix D,

$$D = R_s^{-H/2} R_{xs}^H R_x^{-1} R_{xs} R_s^{-1/2}. \qquad (13)$$

In a next step, the optimal weight for the space-time filter can be obtained by

$$w_{opt} = R_x^{-1} R_{xs} \hat{H}_t, \qquad (MN \times M) \qquad (14)$$

and the optimal channel estimation is

$$h_{opt} = w_{opt}^T \cdot \hat{H}. \qquad (M \times (L+N-1)) \qquad (15)$$

It is then possible to apply the optimal space-time filter in equation (14) to the samples from the antenna array **24**. Clearly the outputs of the filter **30** still have M channels, and it is a MIMO system. The optimal channel estimation in equation (15) can be used for the multi-channel matched filters **32**. The outputs of the matched filter are then combined (summed up) and rescaled in the rescaling circuit **34** to the modified desired level. The final output is a single-channel sample stream and can be fed into the Viterbi equalizer **38**. Note also that the number of channel taps after the JSTOF has been changed to L+N-1 comparing to L of the modeled channel taps before the JSTOF.

It was observed by simulations that the JSTOF receiver incurred more that 1 dB loss in the pure AWGN cases compared to the conventional receiver using the conventional filter. To reduce the loss, a strategy of automatic switching between the JSTOF and conventional receivers was developed. The switching is based on the measurement of the difference of the input and output SINR's of the JSTOF. When the difference is below a predefined threshold the JSTOF receiver is turned off and the conventional receiver is turned on. The input SINR can be easily computed once the estimation of H is done in equation (10):

$$SINR_{inp} = \frac{\left\| \hat{H} \overline{S} \right\|^2}{\left\| \overline{X} - \hat{H} \overline{S} \right\|^2} = \frac{\mathrm{tr}(\hat{H}^* R_s \hat{H}^T)}{\mathrm{tr}(R_x + \hat{H}^* R_s \hat{H}^T - 2\mathrm{Re}\{R_{xs} \hat{H}^T\})}, \qquad (16)$$

and the output SINR can be computed from equations (14) and (15):

$$SINR_{out} = \frac{\left\| h_{opt} \overline{S} \right\|^2}{\left\| w_{opt}^T \overline{X} - h_{opt} \overline{S} \right\|^2} = \frac{\mathrm{tr}(h_{opt}^* R_s h_{opt}^T)}{\mathrm{tr}(w_{opt}^H R_x w + h_{opt}^* R_s h_{opt}^T - 2\mathrm{Re}\{w_{opt}^H R_{xs} h_{opt}^T\})}. \qquad (17)$$

On the mobile side, a virtual antenna array can be set up by the combination of oversampling and the separation of the real and imaginary parts as shown in FIG. 1.

In accordance with various embodiments, the joint optimum MIMO space-time filter and channel estimation set forth in equations (14) and (15) enhances interference suppression performance. The MISO multi-channel matched filters **32**, which are based on the channel estimation in equation (15), improve the error rate performance while reducing the complexity of the Viterbi equalizer **38**. A strategy of automatic switching between JSTOF and conventional receivers reduces the loss in pure AWGN cases.

The JSTOF defined by equations (6)-(17) can be implemented in different ways in terms of numerical stability and computational complexity. The major differences are the way in which the inverse of the autocorrelation matrix $R_x$ is calculated and the way in which the channel $\hat{H}$ is estimated with reduced rank.

One such implementation is a Cholesky decomposition-based matrix inversion of $R_x$ and the eigenvalue decomposition of matrix **D** in equation (13). Specifically, since $R_x$ is symmetric positive definite, the Cholesky decomposition exists:

$$\mathbf{R}_x = \mathbf{L}_x \mathbf{L}_x^T . \qquad (18)$$

D can be rewritten as

$$\mathbf{D} = \mathbf{D}_1 \mathbf{D}_1^T , \qquad (19)$$

where

$$\mathbf{D}_1 = \mathbf{L}_s^{-T} \mathbf{R}_{xs}^T \mathbf{L}_x^{-T} . \qquad (20)$$

It should be noted that the inverse is actually performed with the square-root of $\mathbf{R}_X$, and the explicit computation of the inverse may be avoided by the back-substitution. Also, **D** is numerically stable because of its structure of mutual cancellations. This was verified by simulations that showed the condition number of **D** is seldom greater than 300. This implies the eigenvalue decomposition on **D** would not require unduly sophisticated algorithms for typical applications, as will be appreciated by those skilled in the art. In fact, this approach may potentially have the least computational complexity of the approaches outlined herein.

One potential numerical concern is the Cholesky decomposition on $\mathbf{R}_X$, as its condition number may potentially be relatively high, and its positive definite property may be offset to some degree by round-off errors. Simulations showed, however, that the condition number of $\mathbf{R}_x$ is less than $10^7$ even in some extreme scenarios such as very high and very low carrier-to-interference (C/I) ratios.

In accordance with an alternate embodiment, the QR decomposition in the sample domain may be used to avoid the direct calculation of the inverse of $\mathbf{R}_x$. Since the $\overline{\mathbf{X}}^T$ in equation (3) has full column rank, it has the unique QR decomposition

$$\overline{\mathbf{X}}^T = \mathbf{QR} , \qquad (21)$$

where **Q** is a $p \times MN$ matrix with orthogonal columns and **R** is a full rank $MN \times MN$ upper triangular matrix. It can be shown that

$$\mathbf{R}_x^{-1} = \mathbf{R}^{-1} \mathbf{R}^{-T} , \qquad (22)$$

and the **D** in equation (13) can be written in the form of equation (19) with the $\mathbf{D}_1$ re-defined by

$$\mathbf{D}_1 = \mathbf{L}_s^{-T} \overline{\mathbf{S}} \mathbf{Q} . \qquad (23)$$

The reduced rank channel estimation may be performed with the eigenvalue decomposition on **D** as in the previous approach, and the optimum filter weight matrix of (14) can be reduced as

$$\mathbf{w}_{opt} = \mathbf{R}^{-1} \mathbf{D}_1^T \mathbf{V}_{DM} . \qquad (24)$$

This approach is basically an equivalent version of Cholesky decomposition in the sample domain since one

can show that $\mathbf{R} = \mathbf{L}_x^T$. It has improved numerical stability at the expense of the QR decomposition's greater complexity (requiring approximately twice as many operations for a matrix of given size) and larger sample matrix (having approximately 3 times as many rows in an example case where M=4, N=2 and L=5).

The two approaches described above still require the computation of the triangular matrix inverse, although this may be done by back-substitutions. Turning now to yet another alternate approach, i.e., the singular value decomposition (SVD) approach, the matrix inversion may be avoided and the numerical stability may be further improved in some applications. This approach starts with the SVD on the sample matrix in equation (3):

$$\overline{\mathbf{X}}^T = \mathbf{U}_x \Sigma_x \mathbf{V}_x^T, \qquad (25)$$

where $\mathbf{U}_x$ is a $p \times MN$ matrix with orthogonal columns, $\mathbf{V}_x$ is an $MN \times MN$ orthogonal matrix and $\Sigma_x$ is an $MN \times MN$ diagonal matrix,
$\Sigma_x = diag(\sigma_1, \Lambda, \sigma_{MN})$, with the singular values on its diagonal. It can be shown that

$$\mathbf{R}_x^{-1} = \mathbf{V}_x \Sigma_x^{-2} \mathbf{V}_x^T. \qquad (26)$$

The $\mathbf{D}$ in equation (13) still has the form of equation (19) with $\mathbf{D}_1$ defined by:

$$\mathbf{D}_1 = \mathbf{L}_s^{-T} \overline{\mathbf{S}} \mathbf{U}_x. \qquad (27)$$

The channel estimation may be obtained by the SVD on $\mathbf{D}_1$ and the filter weight matrix may be written as

$$\mathbf{w}_{opt} = \mathbf{V}_x \Sigma_x^{-1} \mathbf{D}_1^T \mathbf{V}_{DM}, \qquad (28)$$

where $\mathbf{V}_{DM}$ contains the top M right singular vectors of $\mathbf{D}_1$. The SVD in this approach may require more computations than the Cholesky and QR decompositions used in the previous two approaches.

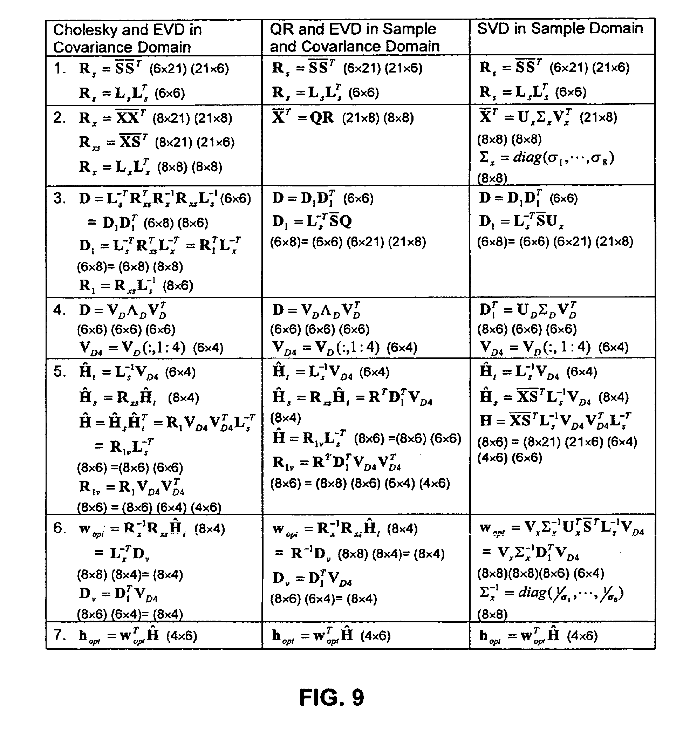

As a comparison of the three approaches outlined above (i.e., Cholesky, QR, and SVD), the table in FIG. 9 lists the computations step by step for an example where M=4, N=2 and L=5. To find the best timing of the burst, the JSTOF searches a number of timing hypotheses and the one corresponding to the minimum output residual is chosen as the best timing. The output residual is defined by:

$$e = \left\| \mathbf{w}_{opt}^T \overline{\mathbf{X}} - \mathbf{h}_{opt}^T \overline{\mathbf{S}} \right\|^2, \qquad (29)$$

The search process basically repeats the operations listed in the table for each hypothesis, but the input sample matrices from the consecutive timing hypotheses change slightly by appending and deleting a column. The updating and the downdating algorithms are potentially applicable to some of the operations, and the overall computation load may potentially be reduced.

Let $\overline{\mathbf{X}}(k)$ represent the sample matrix at time instant $k$. It may be partitioned from equation (3) to

$$\overline{\mathbf{X}}(k) = [\overline{\mathbf{x}}(k), \widetilde{\mathbf{X}}(k+1)], \qquad (30)$$

where

$$\widetilde{\mathbf{X}}(k+1) = [\overline{\mathbf{x}}(k+1), \cdots, \overline{\mathbf{x}}(k+p-1)]. \qquad (31)$$

The sample matrix at time *k+1* may be expressed as

$$\overline{\mathbf{X}}(k+1) = [\widetilde{\mathbf{X}}(k+1), \overline{\mathbf{x}}(k+p)]. \qquad (32)$$

The autocorrelation matrix at time *k+1* has the form

$$\mathbf{R}_x(k+1) = \mathbf{R}_x(k) - \overline{\mathbf{x}}(k)\overline{\mathbf{x}}^T(k) + \overline{\mathbf{x}}(k+p)\overline{\mathbf{x}}^T(k+p). \qquad (33)$$

This is a combination of a rank-1 downdate and a rank-1 update. One hyperbolic rotation-based algorithm for updating/downdating the Cholesky factorization is set forth in Matrix Computations by Golub et al., 3rd edition, 1996.

Another applicable update/downdate algorithm disclosed in Golub et al. text is for QR decomposition, which is based on the Givens rotation. Of course, the given approach that should be used in a particular application will depend on factors such as available processing resources, computational complexity, etc., as will be appreciated by those skilled in the art. Other approaches may also be used, as will also be appreciated by those skilled in the art.

The performance of the JSTOF based receiver has been evaluated by Matlab simulations using an extended BLER simulation engine. The parameters for the JSTOF based receiver can be set with different aspects. Examples of values follow:

1) The oversampling ratio (OSR) of 2 can be selected, which maps to the number of virtual antennas (*M*) of 4 in this non-limiting example, and simulation shows that reducing the OSR to 1 causes significant performance degradations;

2) A number of temporal delayed samples (*N*) can be selected as 2. Increasing the number, however, does not always improve the performance;

3) A reduced rank for the channel response matrix can be selected as M. Increasing or decreasing the rank does not necessarily improve the performance.

4) An auto-switch threshold can be 4.75 dB.

5) A soft decision output can be quantized in 5 bits width. Increasing the width to 8 bits can improve the performance marginally for DTS-5. Soft decision correction can be enabled.

The AMR speech channel, TCH-AFS12.2 can be used to evaluate the performance of the JSTOF in terms of FER. The propagation condition TU50km/h-1950MHz can be assumed throughout the simulations. A simulation ran 1000 trials (blocks) for each case.

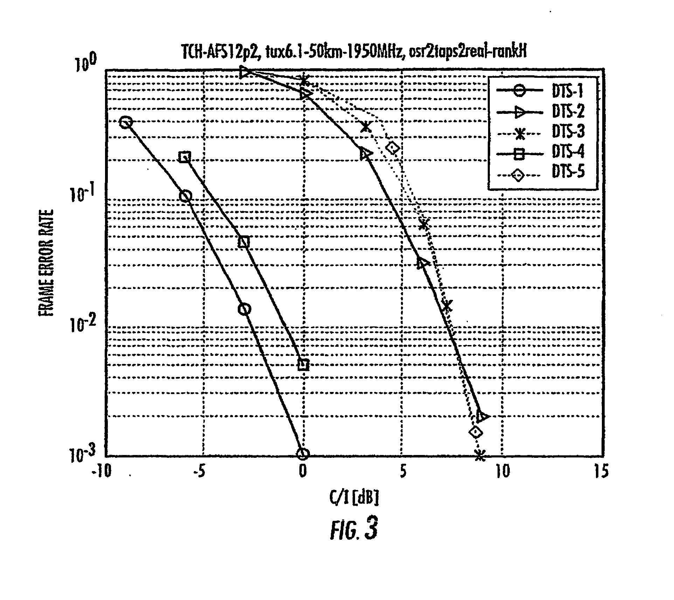

The FER's of the receiver, against the carrier-to-interference (C/I) ratio, are shown in the graph of FIG. 3. The margins against the reference performance specified are listed in the table below.

| Test case | JSTOF performance: C/I at FER = 1%, dB | Spec. performance: C/I at FER = 1%, dB | Margin of JSTOF against Spec., dB |
|-----------|----------------------------------------|----------------------------------------|-----------------------------------|
| DTS-1 | -2.6 | 4 | 6.6 |
| DTS-2 | 7.3 | 9 | 1.7 |
| DTS-3 | 7.6 | 10 | 2.4 |
| DTS-4 | -0.9 | 6 | 6.9 |
| DTS-5 | 7.4 | 9 | 1.6 |

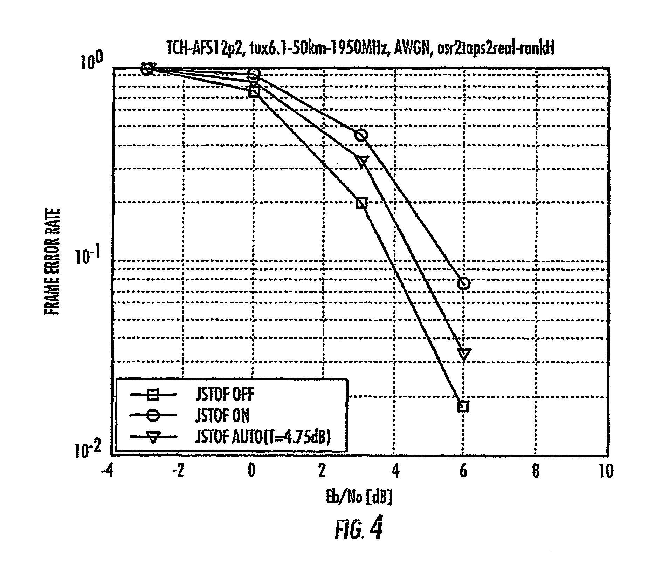

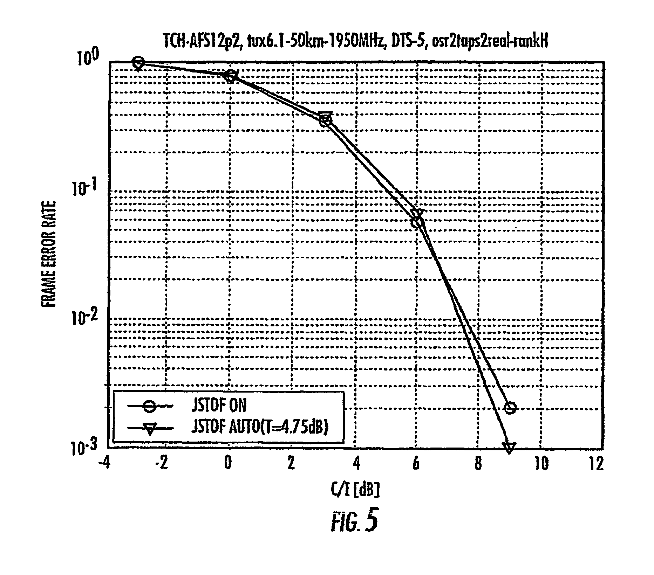

The performance of the receiver under pure AWGN and DTS-5 cases with and without the auto-switching strategy is shown in the graphs of FIG. 4 and FIG. 5, respectively. The strategy reduced the loss in AWGN by about 1 dB (at FER = 10%) and incurred little loss for DTS-5.

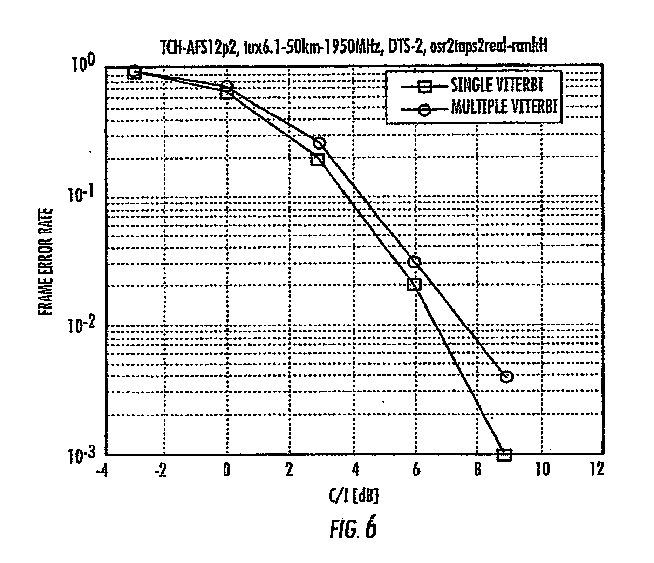

The JSTOF receiver can include multiple Viterbi equalizers, followed by a multi-channel match filter, which combines the soft decisions after the equalizers. A result is shown and compared with the original in the graph of FIG. 6.

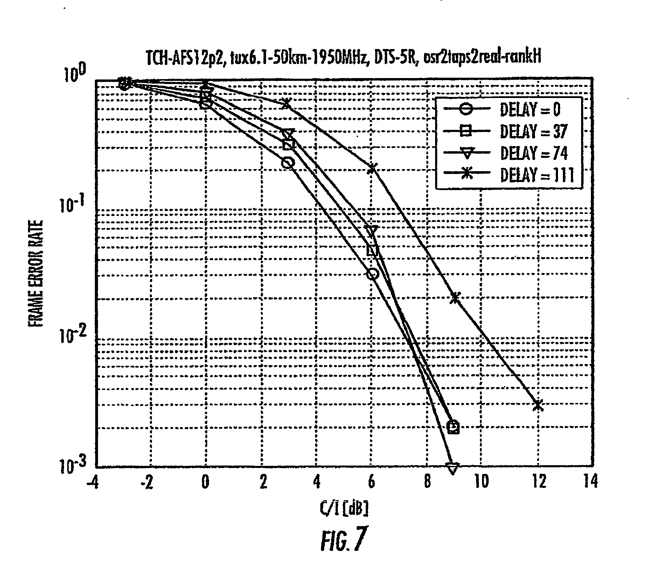

Performance can be evaluated with a modified test case DTS-5R, where the delay of the asynchronous interferer can be configured. The performance at 0, ¼, ½ and ¾ of the burst length is shown in the graph of FIG. 7. The results indicate that the performance of JSTOF receiver degrades "slowly" with severe delay of the interferer.

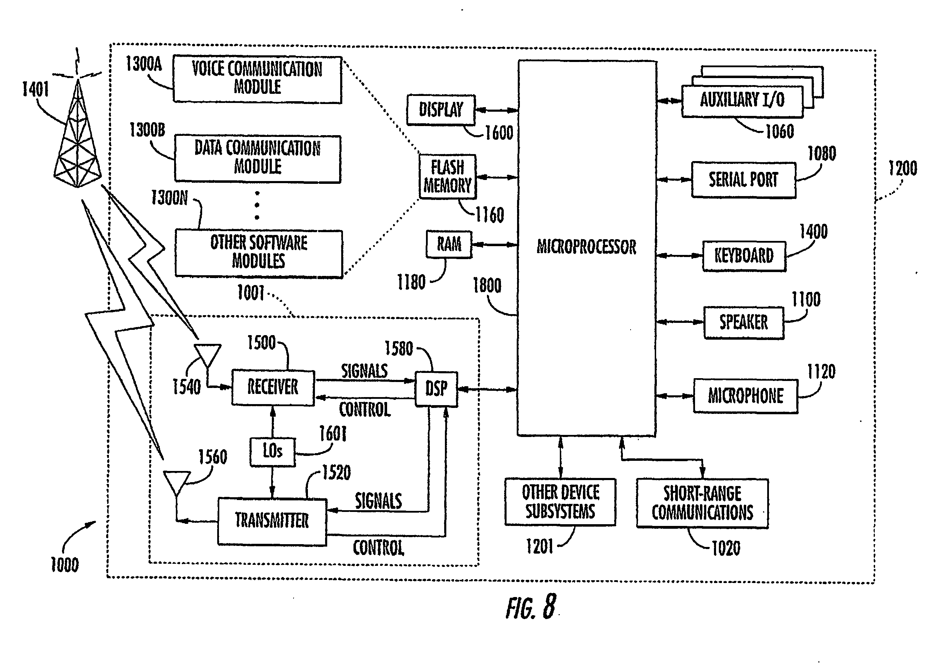

The above-described receiver may advantageously be used in mobile wireless devices (e.g., cellular devices) as well as cellular base stations, for example. An example of a mobile wireless communications device **1000** that may be used is further described in the example below with reference to FIG. 8. The device **1000** illustratively includes a housing **1200,** a keypad **1400** and an output device **1600.** The output device shown is a display **1600,** which is preferably a full graphic LCD. Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400** by the user.

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 8. These include a communications subsystem **1001;** a short-range communications subsystem **1020;** the keypad **1400** and the display **1600,** along with other input/output devices **1060, 1080, 1100** and **1120;** as well as memory devices **1160, 1180** and various other device subsystems **1201.** The mobile device **1000** is preferably a two-way RF communications device having voice and data communications capabilities. In addition, the mobile device **1000** preferably has the capability to communicate with other computer systems via the Internet.

Operating system software executed by the processing device **1800** is preferably stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **1401.** Preferably, the PIM data items are seamlessly integrated, synchronized and updated via the wireless network **1401** with the device user's corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex™, Data TAC™ or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3GPP, UMTS, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device user may also compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device 1000. In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, or a Bluetooth™ communications module to provide for communication with similarly-enabled systems and devices.

Many modifications of the invention will come to the mind of one skilled in the art having the benefit of the teachings presented in the foregoing descriptions and the associated drawings. Therefore, it is understood that the invention is not to be limited to the specific embodiments disclosed, and that modifications are intended to be included within the scope of the invention as defined by the appended claims.

## Claims

1.  A wireless communications device (1000) comprising:

    at least one virtual antenna (24) that splits a received communications signal into n signal parts by sampling the communication signal into even and odd samples and separating the even and odd samples into real and imaginary signal parts;
    a space-time filter circuit (30) for filtering the n signal parts from said at least one virtual antenna (24) by jointly estimating space-time filter weights and at least one channel impulse response;
    a matched filter circuit (32) downstream from said space-time filter circuit and having a filter response that is provided by a channel impulse response estimation from said space-time filter circuit; and
    a further filter (14) operative when an interference level is below a predetermined threshold and comprising a further matched filter circuit (18), a cross-correlation circuit (20), and a switch mechanism (16) for selectively switching the communications signal into said further matched filter circuit (18) and cross-correlation circuit (20).

2.  The wireless communications device (1000) of Claim 1 wherein said space time filter circuit (30) comprises a multi-input, space-time filter circuit that filters the n signal parts by jointly estimating space-time filter weights and associated impulse responses.

3.  The wireless communications device (1000) of Claim 2 wherein said multi-input, space-time filter circuit comprises at least one multiplier (40, 42) for multiplying each signal part by a respective space-time filter weight.

4.  The wireless communications device (1000) of Claim 3 wherein said at least one multiplier (40, 42) comprises a pair thereof connected in parallel; and wherein said multi-input, space-time filter circuit (30) further comprises a respective delay circuit (44) for each signal part connected to an input of one of said pair of multipliers (40, 42).

5.  The wireless communications device (1000) of Claim 4 wherein the communications signal comprises a plurality of symbols; and wherein said multipliers (40, 42) and delay circuits (44) each has a one-symbol delay associated therewith.

6.  The wireless communications device (1000) of Claim 3 further comprising a respective summer circuit (46) for summing outputs of the multipliers for each channel.

7. The wireless communications device (1000) of Claim 1 further comprising an equalizer circuit (38) downstream from said matched filter circuit (32).

8. A method of reducing co-channel interference within a wireless communications device receiver comprising:

providing at least one virtual antenna (24) that splits a received communications signal into n signal parts by sampling the communication signal into even and odd samples and separating the even and odd samples into real and imaginary signal parts;
filtering the n signal parts from the at least one virtual antenna (24) using a space-time filter circuit (30) by jointly estimating space-time filter weights and at least one channel impulse response;
generating a filter response based upon a channel impulse response estimation from the space-time filter circuit using a matched filter circuit (32); and
selectively switching the communications signal into a further filter (14) when an interference level is below a predetermined threshold.

9. The method of Claim 8 wherein the space time filter circuit (30) comprises a multi-input, space-time filter circuit that filters the n signal parts by jointly estimating space-time filter weights and associated impulse responses.

10. The method of Claim 8 further comprising providing an equalizer circuit (38) downstream from the matched filter circuit.

**Patentansprüche**

1. Drahtlose Kommunikationsvorrichtung (1000), die aufweist:

zumindest eine virtuelle Antenne (24), die ein empfangenes Kommunikationssignal in n Signalteile teilt durch Abtasten des Kommunikationssignals in gerade und ungerade Abtastwerte und Trennen der geraden und ungeraden Abtastwerte in reale und imaginäre Signalteile;
eine Raum-Zeit-Filter-Schaltung (30) zum Filtern der n Signalteile von der zumindest einen virtuellen Antenne (24) durch gemeinsames Schätzen von Raum-Zeit-Filter-Gewichtungen und zumindest einer Kanal-Impuls-Antwort;
eine Optimalfilter(matched filter)-Schaltung (32) stromabwärts von der Raum-Zeit-Filter-Schaltung und mit einer Filter-Antwort, die durch eine Kanal-Impuls-Antwort-Schätzung von der Raum-Zeit-Filter-Schaltung vorgesehen wird; und
einen weiteren Filter (14), der betriebsfähig ist, wenn ein Interferenzpegel unter einer vorgegebenen Schwelle ist, und eine weitere Optimalfilter-Schaltung (18), eine Kreuzkorrelations-Schaltung (20) und einen Umschaltmechanismus (16) aufweist zum selektiven Umschalten des Kommunikationssignals in die weitere Optimalfilter-Schaltung (18) und die Kreuzkorrelations-Schaltung (20).

2. Drahtlose Kommunikationsvorrichtung (1000) gemäß Anspruch 1, wobei die Raum-Zeit-Filter-Schaltung (30) eine Mehrfacheingang-Raum-Zeit-Filter-Schaltung aufweist, welche die n Signalteile filtert durch gemeinsames Schätzen von Raum-Zeit-Filter-Gewichtungen und zugehörigen Impuls-Antworten.

3. Drahtlose Kommunikationsvorrichtung gemäß Anspruch 2, wobei die Mehrfacheingang-Raum-Zeit-Filter-Schaltung zumindest einen Multiplizierer (40, 42) aufweist zum Multiplizieren jedes Signalteils mit einer jeweiligen Raum-Zeit-Filter-Gewichtung.

4. Drahtlose Kommunikationsvorrichtung (1000) gemäß Anspruch 3, wobei der zumindest eine Multiplizierer (40, 42) ein Paar davon parallel verbunden aufweist; und wobei die Mehrfacheingang-Raum-Zeit-Filter-Schaltung (30) weiter eine jeweilige Verzögerungsschaltung (44) für jeden Signalteil aufweist, die mit einem Eingang eines des Paares von Multiplizierern (40, 42) verbunden ist.

5. Drahtlose Kommunikationsvorrichtung (1000) gemäß Anspruch 4, wobei das Kommunikationssignal eine Vielzahl von Symbolen aufweist; und wobei die Multiplizierer (40, 42) und Verzögerungsschaltungen (44) jeweils eine zugehörige Verzögerung um ein Symbol haben.

6. Drahtlose Kommunikationsvorrichtung (1000) gemäß Anspruch 3, die weiter aufweist eine jeweilige Summiererschaltung (46) zum Summieren von Ausgaben der Multiplizierer für jeden Kanal.

7. Drahtlose Kommunikationsvorrichtung (1000) gemäß Anspruch 1, die weiter eine Equalizer-Schaltung (38) stromabwärts von der Optimalfilter-Schaltung (32) aufweist.

8. Verfahren zur Reduzierung einer Co-Kanalinterferenz in einem drahtlosen Kommunikationsvorrichtungsempfänger, das aufweist:

Vorsehen zumindest einer virtuellen Antenne (24), die ein empfangenes Kommunikationssignal in n Signalteile teilt durch Abtasten des Kommunikationssignals in gerade und ungerade Abtastwerte und Trennen der geraden und ungeraden Abtastwerte in reale und imaginäre Signalteile;
Filtern der n Signalteile von der zumindest einen virtuellen Antenne (24) unter Verwendung einer Raum-Zeit-Filter-Schaltung (30) durch gemeinsames Schätzen von Raum-Zeit-Filter-Gewichtungen und zumindest einer Kanal-Impuls-Antwort;
Erzeugen einer Filterantwort basierend auf einer Kanal-Impuls-Antwort-Schätzung von der Raum-Zeit-Filter-Schaltung unter Verwendung einer Optimalfilter-Schaltung (32); und
selektives Umschalten des Kommunikationssignals in einen weiteren Filter (14), wenn ein Interferenzpegel unter einer vorgegebenen Schwelle ist.

9. Verfahren gemäß Anspruch 8, wobei die Raum-Zeit-Filter-Schaltung (30) eine Mehrfacheingang-Raum-Zeit-Filter-Schaltung aufweist, welche die n Signalteile filtert durch gemeinsames Schätzen von Raum-Zeit-Filter-Gewichtungen und zugehörigen Impuls-Antworten.

10. Verfahren gemäß Anspruch 8, das weiter aufweist Vorsehen einer Equalizer-Schaltung (38) stromabwärts von der Optimalfilter-Schaltung.


**Revendications**

1. Dispositif (1000) de communications sans fil, comportant :

au moins une antenne virtuelle (24) qui divise un signal reçu de communications en n parties de signal par l'échantillonnage du signal de communication en échantillons pairs et impairs et la séparation des échantillons pairs et impairs en parties réelles et imaginaires de signal ;
un circuit de filtre spatio-temporel (30) destiné à filtrer les n parties de signal provenant de ladite, au moins une, antenne virtuelle (24) en estimant conjointement des facteurs de pondération du filtre spatio-temporel et au moins une réponse impulsionnelle de canal ;
un circuit de filtre adapté (32) en aval dudit circuit de filtre spatio-temporel et ayant une réponse de filtre qui est produite par une estimation de réponse impulsionnelle de canal provenant dudit circuit de filtre spatio-temporel ; et
un autre filtre (14) intervenant lorsqu'un niveau de brouillage est en dessous d'un seuil prédéterminé et comportant un autre circuit de filtre adapté (18), un circuit de corrélation croisée (20), et un mécanisme de commutation (16) destiné à commuter sélectivement le signal de communication dans ledit autre circuit de filtre adapté (18) et ledit circuit de corrélation croisé (20).

2. Dispositif (1000) de communications sans fil selon la revendication 1, dans lequel ledit circuit de filtre spatio-temporel (30) comprend un circuit de filtre spatio-temporel à entrées multiples qui filtre les n parties de signal en estimant conjointement des facteurs de pondération de filtre spatio-temporel et des réponses impulsionnelles associées.

3. Dispositif (1000) de communications sans fil selon la revendication 2, dans lequel ledit circuit de filtre spatio-temporel à entrées multiples comporte au moins un multiplieur (40, 42) destiné à multiplier chaque partie de signal par un facteur de pondération respectif du filtre spatio-temporel.

4. Dispositif (1000) de communications sans fil selon la revendication 3, dans lequel ledit, au moins un, multiplieur (40, 42) comprend une paire de ces multiplieurs connectés en parallèle ; et dans lequel ledit circuit de filtre spatio-temporel (30) à entrées multiples comporte en outre un circuit à retard respectif (44) pour chaque partie de signal appliquée à une entrée de l'un de ladite paire de multiplieurs (40, 42).

**5.** Dispositif (1000) de communications sans fil selon la revendication 4, dans lequel le signal de communications comporte de multiples symboles ; et dans lequel lesdits multiplieurs (40, 42) et lesdits circuits à retard (44) ont chacun un retard d'un symbole qui leur est associé.

**6.** Dispositif (1000) de communications sans fil selon la revendication 3, comportant en outre un circuit sommateur respectif (46) destiné à effectuer une sommation des signaux de sortie des multiplieurs pour chaque canal.

**7.** Dispositif (1000) de communications sans fil selon la revendication 1, comportant en outre un circuit égaliseur (38) en aval dudit circuit de filtra adapté (32).

**8.** Procédé de réduction de brouillage de canal commun dans un récepteur d'un dispositif de communications sans fil comprenant :

l'utilisation d'au moins une antenne virtuelle (24) qui divise un signal reçu de communications en n parties de signal par l'échantillonnage du signal de communication en échantillons pairs et impairs et la séparation des échantillons pairs et impairs en parties réelles et imaginaires de signal ;
le filtrage des n parties de signal provenant de la, au moins une, antenne virtuelle (24) en utilisant un circuit de filtre spatio-temporel (30) par l'estimation conjointe de facteurs de pondération du filtre spatio-temporel et d'au moins une réponse impulsionnelle de canal ;
la génération d'une réponse de filtre basée sur une estimation de la réponse impulsionnelle de canal à partir du circuit de filtre spatio-temporelle en utilisant un circuit de filtre adapté (32) ; et
la commutation sélective du signal de communications dans un autre filtre (14) lorsqu'un niveau de brouillage est en dessous d'un seuil prédéterminé.

**9.** Procédé selon la revendication 8, dans lequel le circuit (30) de filtre spatio-temporel comprend un circuit de filtre spatio-temporel à entrées multiples qui filtre les n parties de signal en estimant conjointement des facteurs de pondération de filtre spatio-temporel et des réponses impulsionnelles associées.

**10.** Procédé selon la revendication 8, comprenant en outre l'utilisation d'un circuit égaliseur (38) en aval du circuit de filtre adapté.

*FIG. 1*

FIG. 2

EP 1 755 298 B1

DEROTATE
COMMUNICATIONS
SIGNAL
— 100

SPLIT INTO
EVEN AND ODD
SAMPLES
— 102

SPLIT INTO
REAL AND IMAGINARY
PARTS
— 104

MULTIPLY AND
DELAY
COMMUNICATIONS
SIGNALS
— 106

SUM AFTER
MULTIPLY AND
DELAY
— 108

MATCH FILTER
SIGNALS
— 110

SUM AFTER
MATCH FILTERING
— 112

VITERBI
EQUALIZER
— 114

MAKE SOFT
DECISION
— 116

FIG. 2A

19

FIG. 3

TCH-AFS12p2, tux6.1-50km-1950MHz, AWGN, osr2taps2real-rankH

FRAME ERROR RATE

Eb/No [dB]

Legend:
- JSTOF OFF
- JSTOF ON
- JSTOF AUTO(T=4.75dB)

FIG. 4

TCH-AFS12p2, tux6.1-50km-1950MHz, DTS-5, osr2taps2real-rankH

FRAME ERROR RATE

C/I [dB]

Legend:
- ○ JSTOF ON
- ▽ JSTOF AUTO(T=4.75dB)

*FIG. 5*

FIG. 6

FIG. 7

FIG. 8

EP 1 755 298 B1

| Cholesky and EVD in Covariance Domain | QR and EVD in Sample and Covariance Domain | SVD in Sample Domain |
|---|---|---|
| 1. $\mathbf{R}_s = \overline{\mathbf{S}}\overline{\mathbf{S}}^T$ (6×21) (21×6) <br><br> $\mathbf{R}_s = \mathbf{L}_s\mathbf{L}_s^T$ (6×6) | $\mathbf{R}_s = \overline{\mathbf{S}}\overline{\mathbf{S}}^T$ (6×21) (21×6) <br><br> $\mathbf{R}_s = \mathbf{L}_s\mathbf{L}_s^T$ (6×6) | $\mathbf{R}_s = \overline{\mathbf{S}}\overline{\mathbf{S}}^T$ (6×21) (21×6) <br><br> $\mathbf{R}_s = \mathbf{L}_s\mathbf{L}_s^T$ (6×6) |
| 2. $\mathbf{R}_x = \overline{\mathbf{X}}\overline{\mathbf{X}}^T$ (8×21) (21×8) <br><br> $\mathbf{R}_{xs} = \overline{\mathbf{X}}\overline{\mathbf{S}}^T$ (8×21) (21×6) <br><br> $\mathbf{R}_x = \mathbf{L}_x\mathbf{L}_x^T$ (8×8) (8×8) | $\overline{\mathbf{X}}^T = \mathbf{QR}$ (21×8) (8×8) | $\overline{\mathbf{X}}^T = \mathbf{U}_x\Sigma_x\mathbf{V}_x^T$ (21×8) <br> (8×8) (8×8) <br> $\Sigma_x = diag(\sigma_1,\cdots,\sigma_8)$ <br> (8×8) |
| 3. $\mathbf{D} = \mathbf{L}_s^{-T}\mathbf{R}_{xs}^T\mathbf{R}_x^{-1}\mathbf{R}_{xs}\mathbf{L}_s^{-1}$ (6×6) <br> $= \mathbf{D}_1\mathbf{D}_1^T$ (6×8) (8×6) <br> $\mathbf{D}_1 = \mathbf{L}_s^{-T}\mathbf{R}_{xs}^T\mathbf{L}_x^{-T} = \mathbf{R}_1^T\mathbf{L}_x^{-T}$ <br> (6×8)= (6×8) (8×8) <br> $\mathbf{R}_1 = \mathbf{R}_{xs}\mathbf{L}_s^{-1}$ (8×6) | $\mathbf{D} = \mathbf{D}_1\mathbf{D}_1^T$ (6×6) <br><br> $\mathbf{D}_1 = \mathbf{L}_s^{-T}\overline{\mathbf{S}}\mathbf{Q}$ <br> (6×8)= (6×6) (6×21) (21×8) | $\mathbf{D} = \mathbf{D}_1\mathbf{D}_1^T$ (6×6) <br><br> $\mathbf{D}_1 = \mathbf{L}_s^{-T}\overline{\mathbf{S}}\mathbf{U}_x$ <br> (6×8)= (6×6) (6×21) (21×8) |
| 4. $\mathbf{D} = \mathbf{V}_D\Lambda_D\mathbf{V}_D^T$ <br> (6×6) (6×6) (6×6) <br> $\mathbf{V}_{D4} = \mathbf{V}_D(:,1:4)$ (6×4) | $\mathbf{D} = \mathbf{V}_D\Lambda_D\mathbf{V}_D^T$ <br> (6×6) (6×6) (6×6) <br> $\mathbf{V}_{D4} = \mathbf{V}_D(:,1:4)$ (6×4) | $\mathbf{D}_1^T = \mathbf{U}_D\Sigma_D\mathbf{V}_D^T$ <br> (8×6) (6×6) (6×6) <br> $\mathbf{V}_{D4} = \mathbf{V}_D(:,1:4)$ (6×4) |
| 5. $\hat{\mathbf{H}}_l = \mathbf{L}_s^{-1}\mathbf{V}_{D4}$ (6×4) <br> $\hat{\mathbf{H}}_s = \mathbf{R}_{xs}\hat{\mathbf{H}}_l$ (8×4) <br> $\hat{\mathbf{H}} = \hat{\mathbf{H}}_s\hat{\mathbf{H}}_l^T = \mathbf{R}_1\mathbf{V}_{D4}\mathbf{V}_{D4}^T\mathbf{L}_s^{-T}$ <br> $= \mathbf{R}_{1v}\mathbf{L}_s^{-T}$ <br> (8×6) = (8×6) (6×6) <br> $\mathbf{R}_{1v} = \mathbf{R}_1\mathbf{V}_{D4}\mathbf{V}_{D4}^T$ <br> (8×6) = (8×6) (6×4) (4×6) | $\hat{\mathbf{H}}_l = \mathbf{L}_s^{-1}\mathbf{V}_{D4}$ (6×4) <br> $\hat{\mathbf{H}}_s = \mathbf{R}_{xs}\hat{\mathbf{H}}_l = \mathbf{R}^T\mathbf{D}_1^T\mathbf{V}_{D4}$ <br> (8×4) <br> $\hat{\mathbf{H}} = \mathbf{R}_{1v}\mathbf{L}_s^{-T}$ (8×6) =(8×6) (6×6) <br> $\mathbf{R}_{1v} = \mathbf{R}^T\mathbf{D}_1^T\mathbf{V}_{D4}\mathbf{V}_{D4}^T$ <br> (8×6) = (8×8) (8×6) (6×4) (4×6) | $\hat{\mathbf{H}}_l = \mathbf{L}_s^{-1}\mathbf{V}_{D4}$ (6×4) <br> $\hat{\mathbf{H}}_s = \overline{\mathbf{X}}\overline{\mathbf{S}}^T\mathbf{L}_s^{-1}\mathbf{V}_{D4}$ (8×4) <br> $\mathbf{H} = \overline{\mathbf{X}}\overline{\mathbf{S}}^T\mathbf{L}_s^{-1}\mathbf{V}_{D4}\mathbf{V}_{D4}^T\mathbf{L}_s^{-T}$ <br> (8×6) = (8×21) (21×6) (6×4) <br> (4×6) (6×6) |
| 6. $\mathbf{w}_{opt} = \mathbf{R}_x^{-1}\mathbf{R}_{xs}\hat{\mathbf{H}}_l$ (8×4) <br> $= \mathbf{L}_x^{-T}\mathbf{D}_v$ <br> (8×8) (8×4)= (8×4) <br> $\mathbf{D}_v = \mathbf{D}_1^T\mathbf{V}_{D4}$ <br> (8×6) (6×4)= (8×4) | $\mathbf{w}_{opt} = \mathbf{R}_x^{-1}\mathbf{R}_{xs}\hat{\mathbf{H}}_l$ (8×4) <br> $= \mathbf{R}^{-1}\mathbf{D}_v$ (8×8) (8×4)= (8×4) <br> $\mathbf{D}_v = \mathbf{D}_1^T\mathbf{V}_{D4}$ <br> (8×6) (6×4)= (8×4) | $\mathbf{w}_{opt} = \mathbf{V}_x\Sigma_x^{-1}\mathbf{U}_x^T\overline{\mathbf{S}}^T\mathbf{L}_s^{-1}\mathbf{V}_{D4}$ <br> $= \mathbf{V}_x\Sigma_x^{-1}\mathbf{D}_1^T\mathbf{V}_{D4}$ <br> (8×8)(8×8)(8×6) (6×4) <br> $\Sigma_x^{-1} = diag(1/\sigma_1,\cdots,1/\sigma_8)$ <br> (8×8) |
| 7. $\mathbf{h}_{opt} = \mathbf{w}_{opt}^T\hat{\mathbf{H}}$ (4×6) | $\mathbf{h}_{opt} = \mathbf{w}_{opt}^T\hat{\mathbf{H}}$ (4×6) | $\mathbf{h}_{opt} = \mathbf{w}_{opt}^T\hat{\mathbf{H}}$ (4×6) |

## FIG. 9

# REFERENCES CITED IN THE DESCRIPTION

## Patent documents cited in the description

- US 68431205 P
- US 60708278 B
- US 6314147 B
- US 5821988 A
- US 20030063596 A

## Non-patent literature cited in the description

- **LIANG et al.** A Two-Stage Hybrid Approach for CCI/ISI Reduction with Space-Time Processing. *IEEE Communication Letter,* November 1997, vol. 1 (6
- **PIPON et al.** Multichannel Receives Performance Comparison In the Presence of ISI and CCI. *1997 13th Intl. Conf. on Digital Signal Processing,* July 1997
- **SPAGNOLINI.** Adaptive Rank-One Receiver for GSM/DCS Systems. *IEEE Trans. on Vehicular Technology,* September 2002, vol. 51 (5
- Feasibility Study on Single Antenna Interference Cancellation (SAIC) for GSM Networks, 3GPP TR 45.903 Version 6.0.1, Release 6. *European Telecommunications Standards Institute,* 2004
- Radio Transmission and Reception (Release 6), 3GPP TS 45.005 Version 6.8.0. *European Telecommunications Standards Institute,* 2005
- **STOICA et al.** Maximum Likelihood Parameter and Rank Estimation in Reduced-Rank Multivariate Linear Regressions. *IEEE Trans. On Signal Processing,* 12 December 1996, vol. 44
- **KRISTENSSON et al.** Blind Subspace Identification of a BPSK Communication Channel. *Proc. 30th Asilomar Conf. On Signals, Systems and Computers,* 1996
- **GOLUB et al.** Matrix Computations. 1996
- **TREFETHEN et al.** *Numerical Linear Algebra,* 1997
- **PRESS et al.** Numerical Recipes in C. 1992
- **Kohno, R.** *Spatial and Temporal Communication Theory Using Adaptive Antenna Array,* February 1998, vol. 5 (1), 28-35